# EUROPÄISCHE PATENTSCHRIFT

(11) **EP 0 500 620 B1**
(45) Veröffentlichungstag und Bekanntmachung des Hinweises auf die Patenterteilung: **27.11.1996**
(21) Anmeldenummer: 90916248.9
(22) Anmeldetag: 07.11.1990
(51) Int. Cl.: G03F 7/36

(54) **VERFAHREN ZUR HERSTELLUNG METALLISCHER MIKROSTRUKTURKÖRPER**
PROCESS FOR THE PRODUCTION OF METAL MICROSTRUCTURE BODIES
PROCEDE DE FABRICATION DE MICROSTRUCTURES METALLIQUES

(30) Priorität: 09.11.1989 DE 3937308
(43) Veröffentlichungstag der Anmeldung: 02.09.1992
(73) Patentinhaber: Forschungszentrum Karlsruhe GmbH, D-76133 Karlsruhe (DE)
(72) Erfinder: BLEY, Peter, D-7514 Eggenstein-Leopoldshafen 2 (DE); HEIN, Herbert, D-7500 Karlsruhe 31 (DE); MOHR, Jürgen, D-7519 Sulzfeld (DE); SCHOMBURG, Werner, D-7500 Karlsruhe 41 (DE)
(74) Vertreter: Gottlob, Peter, Dipl. Ing.
(86) Internationale Anmeldenummer: DE9000841
(87) Internationale Veröffentlichungsnummer: WO9107700

(56) Entgegenhaltungen:
- EP-A- 0 082 977
- EP-A- 0 091 651
- WO-A-84/02986
- DE-A- 3 000 746
- DE-C- 3 712 268
- US-A- 4 347 264
- US-A- 4 657 844

## Beschreibung

Die Erfindung betrifft ein Verfahren zur Herstellung metallischer Mikrostrukturkörper gemäß dem Oberbegriff von Patentanspruch 1.

Verfahren dieser Art sind aus der DE-PS 37 12 268 bzw. der DE-PS 32 06 820 bekannt. Gemäß der DE-PS 37 12 268 wird auf eine metallische Trägerschicht, z.B. aus Chrom-Nickel-Stahl, eine für Röntgenstrahlen empfindliche Resistschicht aufgebracht, die über eine Röntgenmaske partiell mit Synchrotronstrahlung belichtet wird. Die belichteten Bereiche werden mit einem flüssigen Entwickler herausgelöst, wodurch den Mikrostrukturen entsprechende Hohlräume entstehen, die galvanisch unter Verwendung der metallischen Trägerschicht als Elektrode mit einem Metall aufgefüllt werden. Anschließend kann die restliche Resistschicht und je nach Verwendungszweck des Mikrostrukturkörpers auch die Trägerschicht entfernt werden. Mit diesem röntgentiefenlithographisch-galvanoplastischen Verfahren, abgekürzt auch als LIGA-Verfahren bezeichnet, können Mikrostrukturen mit sehr hohen Aspektverhältnissen bei kleinsten, lateralen Abmessungen im µm-Bereich erzeugt werden. Entsprechendes gilt auch für die Elektronenstrahllithographie. Bei der Herstellung von Negativformen aus diesen elektronen- bzw. röntgenstrahlenempfindlichen Kunststoffen in Gestalt von Säulen oder Zapfen mit sehr kleiner Grundfläche tritt das Problem auf, daß einzelne Säulen oder Zapfen keine ausreichende Haftung auf der Trägerplatte haben und deshalb von der Entwicklerflüssigkeit weggespült werden können.

Bei der in der DE-PS 32 06 820 beschriebenen Mikroabformtechnik müssen die Stirnflächen der Mikrostrukuren des Abformwerkzeugs und die hiermit korrespondierende Oberfläche der Trägerplatte extrem plan sein und mit hohem Druck gegeneinander gepreßt werden, damit der flüssig eingebrachte Kunststoff nicht zwischen diese Flächen kriecht und die galvanische Abformung beeinträchtigt, was ebenfalls zu Strukturverlusten führt.

Aus der DE-33 35 171 A1 ist ein Verfahren zur Herstellung von Mikrostrukturen bekannt, bei welchem nach erfolgter Erzeugung einer Kunststoffabformung einer Positiv- oder Urform zunächst ein Fotolackfilm, der zuvor auf die Oberfläche der elektrisch leitfähigen Grundplatte des Abformwerkzeuges aufgebracht wurde und der mit der abgeformten Kunststoffmasse beim Abformvorgang eine innige Verbindung eingehen soll, auf dem Boden der Kunststoffnegativform verbleibt und vor der galvanischen Ausbildung der Positivabformung entfernt wird. Für die Entfernung des Fotolackfilms am Boden der Kunststoffnegativform wird eine Bestrahlung mit UV-Licht und anschließendes Ablösen mittels einer Entwicklerlösung vorgeschlagen. Solche Fotolackfilme haben jedoch keine optimalen Haftvermittlungseigenschaften, weshalb sich diese Methode in der Praxis nicht durchsetzen konnte.

Aus der US-A-4 657 844 ist ein strahlenempfindlicher Negativ-Resist bekannt, der nach der selektiven Bestrahlung erhitzt und sodann zum Entwickeln einem Sauerstoffplasma ausgesetzt wird. Das Sauerstoffplasma entfernt selektiv die Bereiche des Negativ-Resists, die nicht der Strahlung ausgesetzt waren. Generell lassen sich jedoch damit die eingangs genannten, flüssigen Entwickler nicht ersetzen, da - von diesem speziellen Resist abgesehen - strahlenempfindliche Kunststoffe, insbesondere Positiv-Resists, von einem Sauerstoffplasma allseitig und damit strukturzerstörend angegriffen werden. Auch werden bei dem Zwischenschritt des Erhitzens die bestrahlten Bereiche, und damit auch die nach der Entwicklung entstehenden Mikrostrukturen, vergrößert.

Der Erfindung liegt die Aufgabe zugrunde, die gattungsgemäßen Verfahren hinsichtlich der Erzeugung der Negativformen so zu verbessern, daß bei der galvanischen Abformung keine Mikrostrukturverluste oder -fehler auftreten.

Zur Lösung dieser Aufgabe werden die im Kennzeichen von Patentanspruch 1 genannten Maßnahmen vorgeschlagen. Der hierauf bezogene Unteranspruch beinhaltet eine vorteilhafte Ausgestaltung dieser Maßnahmen.

Damit wird erreicht, das die feinen Strukturen der Negativformen, z.B. die erwähnten dünnen Säulen oder Zapfen, zunächst durch einen gemeinsamen Boden miteinander verbunden bleiben. Erst durch das reaktive Ionenätzen, das auf die Strukturen der Negativformen keine hydraulischen oder mechanischen Querkräfte ausübt, werden die Hohlräume zwischen diesen Strukturen bis zur Oberfläche der metallischen Grundplatte freigelegt. Durch dieses anisotrope Trockenätzen ("Fluten"), z.B. mit gegen die Grundplatte beschleunigten Sauerstoff-Ionen, wird zwar auch die oberste Schicht der Kunststoffstrukturen abgetragen; dieser Verlust kann jedoch durch eine entsprechende Erhöhung der auf die Grundplatte aufzubringenden Kunststoffschicht vor deren Bestrahlung kompensiert werden. In jedem Falle werden mit der Erfindung Strukturverluste oder -fehler im entscheidenden lateralen Bereich vermieden.

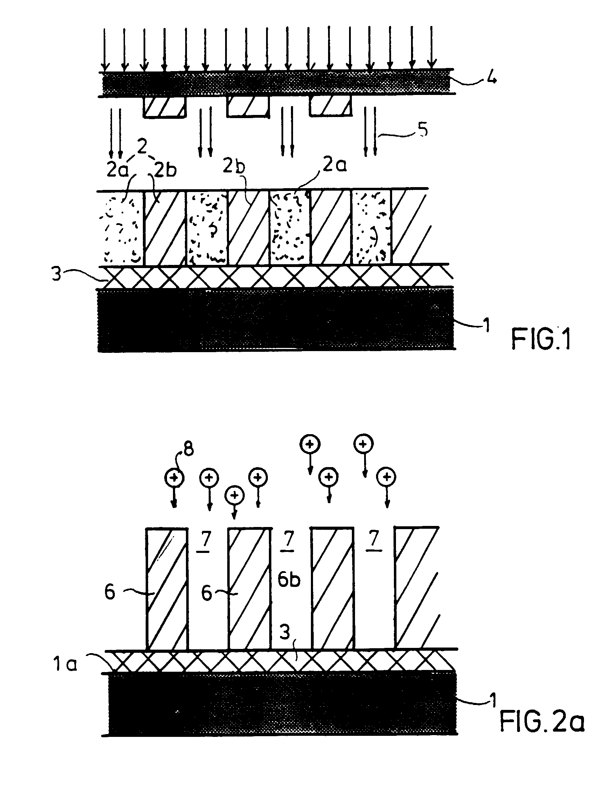

Ausführungsbeispiele der Erfindung werden im folgenden anhand der Figuren 1 bis 4 erläutert.

Die Figur 1 zeigt schematisch eine elektrisch leitfähige Grundplatte 1, auf die eine Schicht 2 aus einem elektronen- oder röntgenstrahlenempfindlichen Kunststoff (Resist) aufgebracht ist. Zwischen Grundplatte 1 und Schicht 2 ist eine dünne, als Haftvermittler dienende Zwischenschicht 3 aus einem Kunststoff angeordnet, die zuvor auf die Grundplatte 1 aufgebracht wurde und die nicht elektronen- oder röntgenstrahlenempfindlich ist. Die Schicht 2 wird über eine Maske 4 mit Elektronen- oder Röntgenstrahlung 5 belichtet, so daß in der Schicht 2 abwechselnd bestrahlte und unbestrahlte Bereiche 2a, 2b entstehen. Die bestrahlten Bereiche 2a entsprechen der Struktur des herzustellenden, metallischen Mikrostrukturkörpers.

Durch Entwickeln und Herauslösen der bestrahlten Bereiche 2a mit einer Entwicklerflüssigkeit entsteht auf der verbliebenen Zwischenschicht 3 eine Negativform aus hohen, dünnen Säulen oder Zapfen 6, die durch die Haftkräfte der Schicht 3 fest mit dieser und hierüber auch mit der Grundplatte 1 verbunden bleiben (Figur 2a).

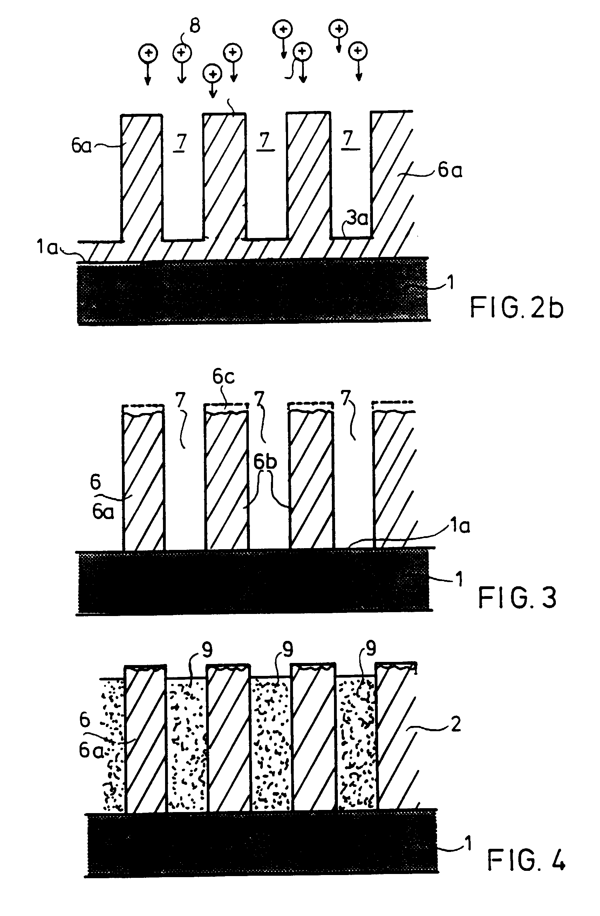

Eine ähnliche Konfiguration zeigt Figur 2b. In diesem Beispiel wurden die Säulen oder Zapfen 6a der Kunststoff-Negativform mittels der eingangs genannten Mikroabformtechnik hergestellt. Dabei wurde bewußt in Kauf genommen, daß beim Abformen eine dünne Restschicht 3a des Kunststoffs als Boden der Hohlräume 7 zwischen den Zapfen 6a auf der Grundplatte 1 belassen wurde.

Die Restschicht 3a bzw. die Zwischenschicht 3 (Figur 2a) am Boden der Hohlräume 7 werden durch reaktives Ionenätzen in der Weise entfernt, daß Sauerstoff-Ionen 8 eines Sauerstoffplasmas senkrecht zur Oberfläche 1a der Grundplatte 1 beschleunigt werden und diese Böden wegätzen (Figur 3). Die Reaktionsprodukte von Kunststoff und Sauerstoff sind gasförmig und können daher leicht auch aus engen, spaltförmigen Hohlräumen entweichen. Für die Grundplatte 1 ist ein Material, z.B. Chrom-Nickel-Stahl, zu verwenden, das nicht in einer die Galvanik störenden Weise von den Sauerstoff-Ionen 8 angegriffen wird. Da die Sauerstoff-Ionen 8 senkrecht zur Oberfläche 1a der Grundplatte 1 hin beschleunigt werden, erfolgt kein Materialabtrag an den seitlichen Wänden 6b der Säulen 6, 6a. Hingegen erfolgt durch dieses anisotrope Trockenätzen mit Sauerstoff ein gewisser Materialabtrag an den freien Stirnflächen 6c der Säulen 6, der jedoch durch eine entsprechende Erhöhung der Schichtdicke der zu behandelnden Kunststoffschicht 2 berücksichtigt werden kann. Da bei dieser Art des Ionenätzens auf die Säuelen 6, 6a der Negativformen keine lateralen Kräfte ausgeübt werden, bleiben die Säulen auch bei kleinen Querschnitts- bzw. -grundflächen fest und formbeständig auf der Oberfläche la der Grundplatte 1 stehen. Das galvanische Auffüllen der Hohlräume 7 mit einem Metall 9 unter Verwendung der Grundplatte 1 als Elektrode erfolgt sodann in bekannter Weise (Figur 4). Anschließend können die Kunststoffsäulen 6, 6a zur Freilegung des metallischen Mikrostrukturkörpers 1, 9 mit einem Lösungsmittel entfernt werden.

Die Praxis hat gezeigt, daß bereits sehr dünne Restschichten am Boden der Hohlräume ausreichen, um den erfindungsgemäßen Erfolg sicherzustellen. Bei mit der Elektronenstrahllithographie hergestellten Säulen mit 1 µm Durchmesser und mehreren µm Höhe genügt es, beim Arbeiten ohne Haftvermittler die Naßentwicklung zu stoppen, wenn am Boden zwischen den Säulen noch eine Restschichtdicke von 0,1 bis 0,2 µm vorhanden ist. Auch erfolgt nach dem reaktiven Sauerstoff-Ionenätzen ein sehr guter Start der Galvanik auf den so freigelegten Flächen der Metallgrundplatte.

Auch bei der Herstellung von Negativformen mit der Röntgentiefenlithographie bzw. der hiervon abgeleiteten Mikroabformtechnik kann mit Hilfe der erfindungsgemäßen Behandlung die Ausschußrate gegen null gesenkt werden. Bei einer Strukturhöhe der Negativformen von 300 µm und Spaltweiten der Hohlräume von 10 µm wurden durch das Ionenätzen alle Resistreste aus den Spalten entfernt. Durch das Vermeiden einer Durchentwicklung bis zur Grundplatte aufgrund der erfindungsgemäßen Nachbehandlung, die quasi das "Durchentwickeln" übernimmt, werden auch von daherrührende Strukturfehler vermieden.

Eine Vermessung einer derartigen Negativform ergab, das durch die Behandlung mit den Sauerstoff-Ionen kein meßbarer Abtrag an den Seitenwänden der Negativform erfolgte. Der Abtrag an der freien Oberfläche betrug etwa 5 µm.

## Patentansprüche

1. Verfahren zur Herstellung von metallischen Mikrostrukturkörpern, bei dem auf einer elektrisch leitfähigen Grundplatte mittels Elektronenstrahllithographie, Röntgenlithographie oder Mikroabformtechnik Negativformen der Mikrostrukturen aus Kunststoff erzeugt und die Hohlräume der Negativformen galvanisch unter Verwendung der elektrisch leitfähigen Grundplatte als Elektrode mit Metall aufgefüllt werden,
dadurch gekennzeichnet, daß
a) im Zuge der Erzeugung der Negativformen (6, 6a) eine Restschicht (3a) des Kunststoffes oder eine als Haftvermittler dienende, auf die Grundplatte (1) aufgebrachte Zwischenschicht (3) aus einem Kunststoff als Boden der Hohlräume (7) der Negativformen auf der Grundplatte (1) belassen wird, und daß
b) vor dem galvanischen Auffüllen der Hohlräume (7) der Negativformen (6, 6a) mit Metall (9) die Restschicht (3, 3a) des Kunststoffes am Boden der Hohlräume (7) durch reaktives Ionenätzen mittels senkrecht gegen die Oberfläche (1a) der Grundplatte (1) beschleunigter Ionen (8) entfernt wird.

2. Verfahren nach Anspruch 1, dadurch gekennzeichnet, daß zum reaktiven Ionenätzen ein Sauerstoffplasma verwendet wird.

## Claims

1. Process for manufacture of metal made microstructure bodies, with plastic negative molds of the microstructures produced by electron beam lithography, X-ray lithography or micromolding on an electrically conducting base plate and with the cavities of the negative molds filled with electroplated metal using the electrically conducting base plate as electrode,
characterized by
(a) a residual layer (3a) of the plastic or a plastic intermediate layer (3) applied to the base plate (1) as adhesion promoter left on the base plate (1) as the bottom of the cavities (7) of the negative molds while the negative molds (6, 6a) are produced, and
(b) the residual layer (3, 3a) of the plastic on the bottom of the cavities (7), prior to filling with electroplated metal (9) of the cavities (7) of the negative molds (6, 6a), stripped by reactive ion etching using ions (8) accelerated in a direction normal to the surface (1a) of the base plate (1).

2. Process as claimed in (1) characterized by use of an oxygen plasma for reactive ion etching.

## Revendications

1. Procédé de fabrication de microstructures métalliques, selon lequel on réalise en matière plastique des moules négatifs des microstructures, sur une plaque de base conductrice de l'électricité, par lithographie par rayonnement électronique ou par rayons X, ou par la technique du micromoulage et on remplit de métal les creux des micromoulages, par galvanoplastie en utilisant la plaque de base comme électrode, ces procédés présentant les caractéristiques suivantes :
a) dans le cadre de la réalisation des moules négatifs (6, 6a) une couche résiduelle (3a) de matière plastique ou une couche intermédiaire (3) de matière plastique déposée sur la plaque de base (1) pour servir d'agent d'accrochage, est abandonnée sur cette plaque (1) au fond des creux (7) des moules négatifs,
b) avant le remplissage par galvanoplastie des creux (7) des moules négatifs (6, 6a) par du métal (9), la couche résiduelle (3, 3a) de matière plastique laissée au fond du creux (7) est éliminée par attaque ionique réactive au moyen d'ions (8) accélérés perpendiculaires à la surface (la) de la plaque de base (1).

2. Procédé selon la revendication 1,
caractérisé en ce qu'
on utilise un plasma d'oxygène pour réaliser l'attaque ionique réactive.
